**Europäisches Patentamt**

**European Patent Office**

**Office européen des brevets**

(19)

(11) Veröffentlichungsnummer: **0 342 358**

**A1**

(12) # EUROPÄISCHE PATENTANMELDUNG

(21) Anmeldenummer: **89106681.3**

(22) Anmeldetag: **14.04.89**

(51) Int. Cl.⁴: **H01L 21/00**

(30) Priorität: **18.05.88 CH 1876/88**
**20.02.89 CH 589/89**

(43) Veröffentlichungstag der Anmeldung:
**23.11.89 Patentblatt 89/47**

(84) Benannte Vertragsstaaten:
**AT BE CH DE FR GB IT LI NL SE**

(71) Anmelder: **ESEC SA**
**Hinterbergstrasse 32**
**CH-6330 Cham/Steinhausen(CH)**

(72) Erfinder: **Japichino, Emanuele**
**Dorfbachstrasse 24**
**CH-6430 Schwyz(CH)**
Erfinder: **Meisser, Claudio**
**Moosstrasse 14**
**CH-6330 Cham(CH)**

(74) Vertreter: **EGLI-EUROPEAN PATENT**
**ATTORNEYS**
**Horneggstrasse 4**
**CH-8008 Zürich(CH)**

(54) **Verfahren und Einrichtung zum Bereitstellen eines Bonddrahtes.**

(57) Es wird ein Verfahren und eine Einrichtung zur Durchführung des Verfahrens vorgeschlagen, mittels welchem/welcher ein Bonddraht (Golddraht) berührungslos von einer um ihre Längsachse drehbar gelagerten Bonddrahtspule (25 oder 125) abgezogen und einer Einrichtung (90 oder 190) der Halbleiter-Verbindungstechnik zur Bildung von Schaltkreisen an elektronischen Komponenten (80 oder 180) zugeführt wird.

Die als eine Baueinheit ausgebildete Abzugseinrichtung (100 oder 200) umfasst im wesentlichen einen an einer Trägerplatte (10 oder 110) angeordneten, elektromotorisch angetriebenen Spulenträger (15 oder 115) für die Bonddrahtspule sowie eine mit mindestens einem optronischen Sensor (56 oder 156) versehene Abzugsstation (30 oder 130).

Der mittels entsprechender Luftströme (P' oder Q') zur Bildung einer Bonddrahtreserve in der Abzugsstation (30 oder 130) umgelenkte Bonddraht (26 oder 126) wird von dem optronischen Sensor (56 oder 156) abgetastet und bei abnehmender Bonddrahtreserve in Abhängigkeit von der Lage des Bonddrahtes ein Signal erzeugt, welches im wesentlichen in einem Signalauswertgerät (70 oder 170) verarbeitet wird und mittels welchem über eine Steuereinheit (75 oder 175) ein mit dem Spulenträger (15 oder 115) wirkverbundener, elektromotorischer Antrieb (20) betätigt wird.

FIG. 2

## Verfahren und Einrichtung zum Bereitstellen eines Bonddrahtes

Die Erfindung betrifft ein Verfahren und eine Einrichtung zum Bereitstellen eines Bonddrahtes zur Bildung von Schaltkreisen an elektronischen Komponenten, bei welchem der Bonddraht in einer Abzugsstation durch mindestens einen quer zur Transportrichtung orientierten Luftstrom zur Bildung einer Drahtreserve beaufschlagt und zur Ansteuerung eines mit der Spule in Wirkverbindung stehenden elektromotorischen Antriebs von einem Sensor optronisch detektiert oder abgetastet wird.

Aus der EP-A 0 130 104 ist eine Vorrichtung zur Bildung einer Bonddrahtreserve bekannt, bei welcher der durch einen ersten Rohrstutzen eingeführte und zwischen zwei zu einem Gehäuse zusammenklappbaren Platten von einem Luftstrom beaufschlagte Bonddraht einen zweiten Stutzen durchdringend aus dem Gehäuse geführt wird. Die von dem Luftstrom zwischen den beiden Platten schlaufenartig gebildete Drahtreserve wird von mehreren, hintereinander in Reihe und orthogonal zur Durchlaufrichtung zu beiden Seiten des Bonddrahtes im Abstand zueinander angeordneten Sensoren abgetastet. Die dabei ermittelten Werte werden zur Ansteuerung eines elektromotorischen Antriebs sowie zum Abzug des Bonddrahts von der Spule verwendet.

Aus der EP-A 0 226 126 ist zum automatischen Legen von Feindrähten eine Drahtabziehvorrichtung bekannt, bei welcher der zwischen zwei im Abstand zueinander angeordneten Platten in einer Schlaufenkammer angeordnete Draht mit Druckluft beaufschlagt und beim Erreichen einer bestimmten Schlaufengrösse ein entsprechend angeordneter Taster betätigt und von diesem die Zufuhr der Druckluft abgeschaltet wird.

In Verbindung mit der Halbleiter-Verbindungstechnik, insbesondere zur Ultraschall kontaktierenden Drahtverbindung von Schaltkreisen an elektronischen Komponenten wie Chips oder dergleichen wird der Bonddraht (im μ-Bereich liegender Golddraht) von einer um ihre Längsachse drehbar gelagerten Bonddrahtspule abgezogen.

Bei den bekannten Einrichtungen besteht das Problem, dass der motorisch von der Bonddrahtspule abgezogene Bonddraht durch Kontaktieren entsprechender Elemente umgelenkt und überwacht und dadurch die Freigabe des Bonddrahtes von der Spule entsprechend gesteuert wird. Diese im wesentlichen mechanische Umlenkung und Abtastung führt oftmals zum Zerreissen des Bonddrahtes und somit zum wartungs- und kostenintensiven Stillstand der kompletten Einrichtung. Ein weiterer Nachteil wird bei den bekannten Vorrichtungen im komplizierten und arbeitsaufwendigen Einfädeln oder Einlegen des Bonddrahtes gesehen.

Der Erfindung liegt die Aufgabe zugrunde, ein Verfahren und eine Einrichtung zur Durchführung des Verfahrens anzugeben, mittels welchem/welcher ein hochempfindlicher Bonddraht berührungslos von der Bonddrahtspule abgezogen, umgelenkt und funktionell zuverlässig dem Kontaktierorgan (Bondkopf) zugeführt werden kann.

Das erfindungsgemässe Verfahren ist dadurch gekennzeichnet, dass der Bonddraht von einem einzigen, quer zur Transportrichtung angeordneten Sensor detektiert und von mindestens einem im wesentlichen entgegengesetzt in Richtung des Sensors orientierten ersten Luftstroms im optischen Wirkungsbereich des Sensors gehalten wird, und dass. sobald der Bonddraht den optischen Wirkungsbereich des Sensors verlässt von diesem ein den elektromotorischen Antrieb entsprechend betätigendes Signal zur Bildung einer neuen Drahtreserve erzeugt wird.

Die erfindungsgemässe Bonddraht-Abzugseinrichtung zur Durchführung des Verfahrens besteht aus einem mit einem elektromotorischen Antrieb wirkverbundenen Spulenträger für eine Spule und einer entsprechend zugeordneten Abzugsstation, mit zwei im Abstand zueinander angeordneten Platten, zwischen welchen der von einem Luftstrom einer Druckluftquelle beaufschlagte Bonddraht zur Bildung einer Drahtreserve angeordnet ist und ist dadurch gekennzeichnet, dass

- in den beiden Platten je eine quer zur Transportrichtung des Bonddrahtes orientierte und in zusammengebautem Zustand der Platten einen Lichtkanal bildende Ausnehmung für einen optronischen Sensor angeordnet ist, und

- die Abzugsstation für die jeweils erforderlichen Luftstrahlen entweder über Kanalsystem oder über einen entsprechend zugeordneten Düsenkörper mit der Druckluftquelle wirkverbunden sind.

Weitere Merkmale der Erfindung ergeben sich aus der folgenden Beschreibung in Verbindung mit der Zeichnung und den Patentansprüchen.

Die Erfindung wird nachstehend unter Bezugnahme auf die Zeichnung näher beschrieben. Es zeigt:

Fig.1 eine in schematischer Ansicht dargestellte erste Ausführungsform einer Bonddraht-Abzugseinrichtung,

Fig.2 eine in Draufsicht und im Schnitt dargestellte Abzugsstation für die Einrichtung gemäss Fig.1,

Fig.3 die in Schnittansicht gemäss der Linie III-III in Fig.2 dargestellte Abzugsstation,

Fig.4 eine zweite Ausführungsform einer Bonddraht-Abzugseinrichtung,

Fig.5 eine im Schnitt dargestellte Abzugsstation für die Einrichtung gemäss Fig.4,

Fig.6 die in Schnittansicht gemäss der Linie VI-VI in Fig.5 dargestellte Abzugsstation,

Fig.7 die im Schnitt und in Draufsicht dargestellte Abzugsstation gemäss der Linie VII-VII in Fig.6.

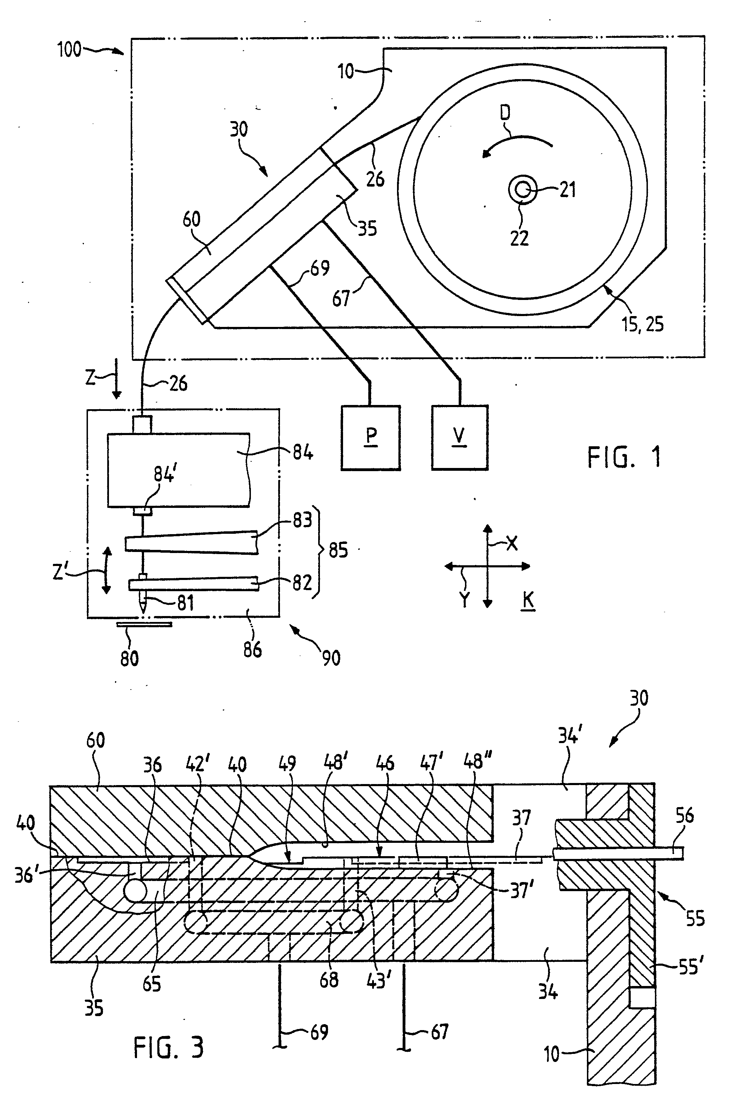

Fig.1 zeigt in Ansicht eine erste Ausführungsform einer in der Gesamtheit mit 100 bezeichneten Bonddraht-Abzugseinrichtung der Halbleiter-Verbindungstechnik, welche Abzugseinrichtung 100 mit einer entsprechend zur Ultraschall kontaktierenden Drahtverbindung und zur Bildung von Schaltkreisen oder dergleichen an elektronischen Komponenten 80 (Chips) ausgebildeten Einrichtung 90 funktionell wirkverbunden ist.

Die in Fig.1 symbolisch dargestellte und als Bondkopf ausgebildete Einrichtung 90 umfasst ein durch die strichpunktierten Linien im Umriss dargestelltes Trägerelement 86, an welchem ein mit einem optischen Abtastelement 84′ (Sensor) versehener Ausleger 84 angeordnet ist. In dem nicht näher dargestellten, gehäuseartig ausgebildeten Trägerelement 86 ist ein Kontaktierorgan 85 angeordnet, welches im wesentlichen eine Klemmvorrichtung 83 sowie ein US-Hornstück 82 (Ultraschallhorn) mit daran angeordneter Kapillare 81 umfasst. Das aus den einzelnen, wesentlichen Funktionsteilen 81,82,83 gebildete und im Trägerelement 86 angeordnete Kontaktierorgan 85 ist mittels einem damit wirkverbundenen elektromotorischen Antrieb (nicht dargestellt) um eine im Trägerelement 86 vorgesehene, nicht dargestellte Gelenkstelle oder Schwenkachse in Pfeilrichtung Z′ schwenkbar, wobei das mit dem Ausleger 84 und Kontaktierorgan 85 als eine Baueinheit ausgebildete Trägerelement 86 mit nicht dargestellten elektromotorischen Antrieben in Wirkverbindung steht und gemäss dem in Fig.1 dargestellten Koordinatensystem K (versetzt dar gestellt) in der Ebene gemäss Pfeilrichtung X und/oder Y verstellbar ist.

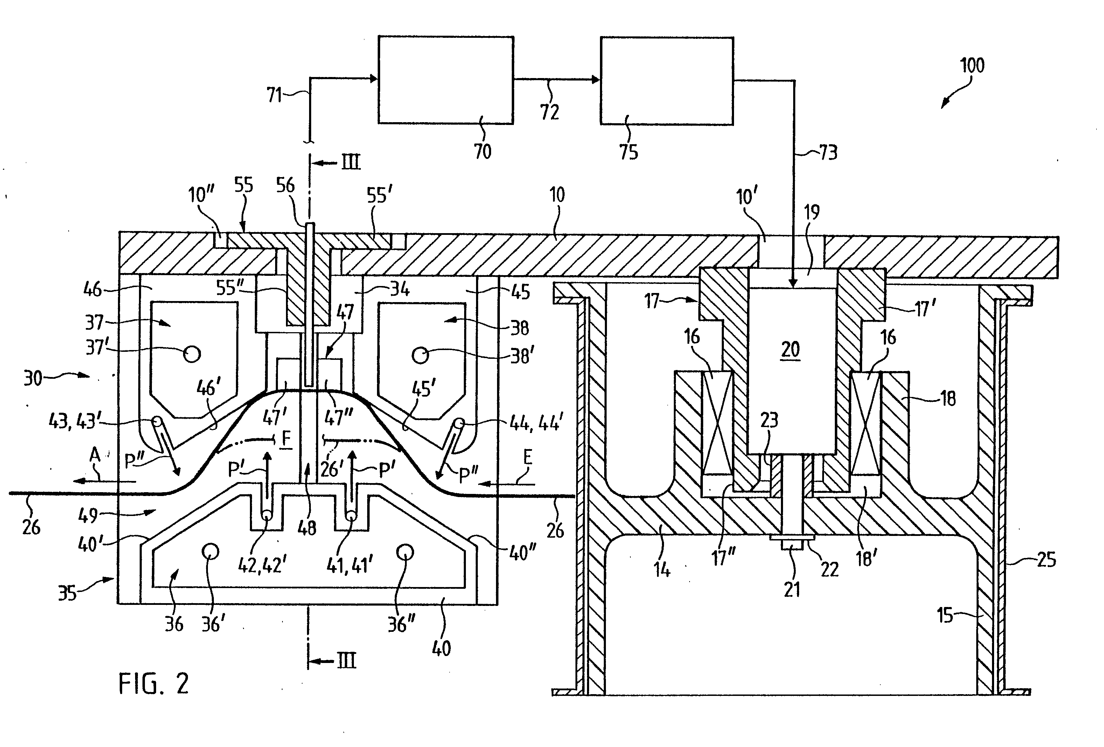

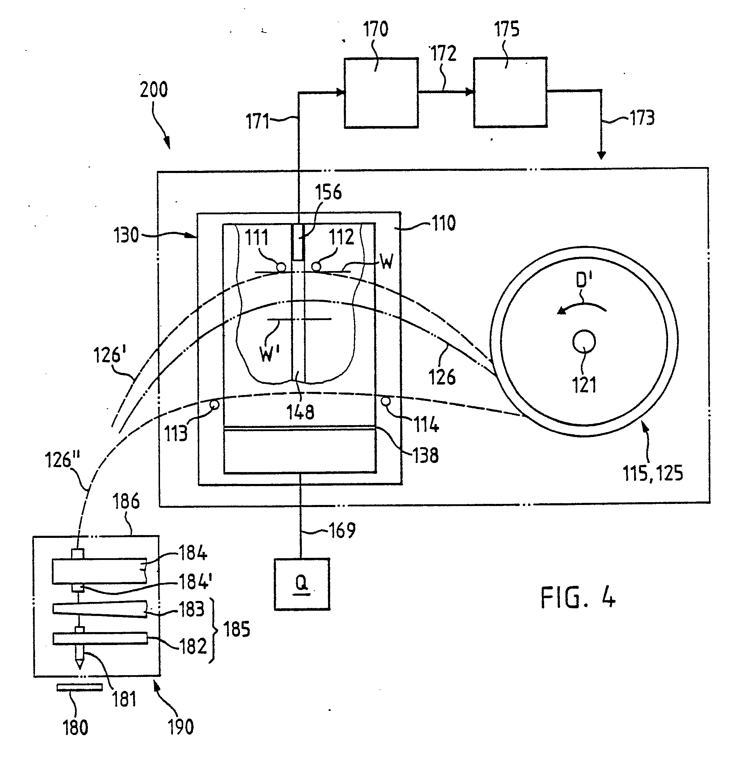

Die in Fig.1 dargestellte Bonddraht-Abzugseinrichtung 100 hat eine Trägerplatte 10, an welcher ein zur Aufnahme einer Bonddrahtspule 25 ausgebildeter Spulenträger 15 sowie eine in der Gesamtheit mit 30 bezeichnete und im wesentlichen mit den Teilen 15,25 wirkverbundene Abzugsstation angeordnet ist. Die Abzugsstation 30 ist für einen etwa in Pfeilrichtung Z orientierten, kontinuierlichen Abzug eines mit 26 bezeichneten Bonddrahtes (Golddraht) von der Spule 25 ausgebildet und wird später in Verbindung mit Fig.2 und Fig.3 im einzelnen beschrieben. Die auswechselbare Spule 25 ist in axialer Richtung auf den Spulenträger 15 aufschiebbar und mit in Fig.1 nicht näher dargestellten Mitteln mit dem um eine Achse 21 in Pfeilrichtung D drehbar angetriebenen Spulenträger 15 wirkver

bunden.

In Fig.2 ist in Draufsicht und im Schnitt die Bonddraht-Abzugseinrichtung 100 dargestellt und man erkennt den an der Trägerplatte 10 angeordneten Spulenträger 15 mit der Spule 25 sowie die entsprechend zugeordnete und damit wirkverbundene Abzugsstation 30.

An der Trägerplatte 10 ist zur Lagerung des Spulenträgers 15 ein etwa als Buchsenkörper ausgebildetes Trägerelement 17 angeordnet, welches mit einem ersten, flanschartig ausgebildeten Teilstück 17′ an der Trägerplatte 10 gelagert und mit nicht dargestellten Mitteln daran lösbar befestigt ist. Ein zweites, abgesetzt ausgebildetes Teilstück 17″ des Trägerelements 17 ist zur Aufnahme eines Wälzlagers, beispielsweise eines Nadellagers 16 ausgebildet. Das Teilstück 17″ mit dem Nadellager 16 ist bei dieser Ausführungsvariante in einer Ausnehmung 18′ eines an einem stegartigen Zwischenstück 14 angeformten Nabenstück 18 des Spulenträgers 15 angeordnet. Bei kleineren Bonddrahtspulen 25 kann dieses in nicht näher dargestellter Weise direkt auf dem Nabenstück 18 angeordnet werden.

In dem von einer Bohrung 19 in axialer Richtung durchdrungenen Trägerelement 17 ist ein schematisch dargestellter und mit der Antriebsachse 21 versehener, elektromotorischer Antrieb 20 angeordnet. Als Antrieb 20 ist vorzugsweise ein Gleichstrommotor mit integriertem Reduktionsgetriebe vorgesehen. Der Spulenträger 15 ist auf der das Zwischenstück 14 des Spulenträgers 15 durchdringenden und mit einer Distanzbuchse 23 versehenen Antriebsachse 21 gelagert und mittels einem Sprengring 22 oder dergleichen auf der Antriebsachse 21 gesichert und gehalten. Der mit der Spule 25 versehene Spulenträger 15 ist in nicht näher dargestellter Weise mit der Antriebsachse 21 wirkverbunden und durch den Antrieb 20 in Pfeilrichtung D (Fig.1) drehbar angetrieben.

Im Abstand zu dem Spulenträger 15 und in Abzugsrichtung des Bonddrahtes 26 gesehen (Fig.1) ist an der Trägerplatte 10 die mit nicht dargestellten Mitteln daran vorzugsweise lösbar befestigte Bonddraht-Abzugsstation angeordnet, welche Abzugsstation 30 im wesentlichen, wie in Fig.3 im Profilquerschnitt dargestellt, eine Auflageplatte 35 sowie eine damit wirkverbundene Abdeckplatte 60 (Fig.1) umfasst und nachstehend im einzelnen beschrieben wird:

Die Auflageplatte 35 ist, wie in Fig.2 dargestellt, mit einer ersten Vakuumzone 36, einer zweiten Vakuumzone 37 sowie einer dritten Vakuumzone 38 versehen. In den einzelnen Vakuumzonen 36,37 und 38 ist je mindestens eine Ansaugbohrung oder Öffnung angeordnet, welche durch ein Kanalsystem 65 (Fig.3) miteinander verbunden und über eine Leitung 67 an eine Vakuumpumpe V (Fig.1) angeschlossen sind. Im dargestellten Ausführungsbeispiel ist die erste Vakuumzone 36 mit zwei im Abstand zueinander angeordneten Öffnungen 36´,36´´, die zweite Vakuumzone 37 mit einer Öffnung 37´ und die dritte Vakuumzone 38 mit einer Öffnung 38´ versehen. Die einzelnen Vakuumzonen 36,37 und 38 sind weiterhin jeweils von einer entsprechend zugeordneten, etwa stegartig ausgebildeten und die jeweilige Vakuumzone vollumfänglich umgreifenden Trenn leiste 40,45 und 46 umgeben, wobei zwischen den beiden korrespondierend zueinander angeordneten Vakuumzonen 37 und 38 ein weiteres durch eine Ausnehmung 48 (Lichtkanal) in zwei Teilstücke 47´,47´´ unterteiltes Trennelement 47 vorgesehen ist.

Die Trennleisten 40,45 und 46 sowie das Teil 47 sind in bezug zu den einzelnen, nicht näher bezeichneten Grundflächen der Vakuumzonen 36,37 und 38 erhaben ausgebildet und dienen als Auflage für die Abdeckplatte 60 (Fig.3).

Zwischen der Trennleiste 40 und den beiden im Abstand dazu angeordneten Trennleisten 45 und 46 ist ein für den Bonddraht ausgebildeter Führungskanal 49 vorgesehen, welcher in bezug zu den nicht näher bezeichneten Oberkanten der einzelnen Trennleisten tiefer, d.h., etwa die gleiche Lage wie die Grundflächen (nicht bezeichnet) der Vakuumzonen 36,37 und 38 einnimmt. Der Führungskanal 49 wird im wesentlichen durch schräge Kanten 45´ und 46´, der beiden Trennleisten 45 und 46 sowie durch schräge Kanten 40´ und 40´´ der korrespondierend dazu angeordneten Trennleiste 40 gebildet. Die etwa in parallelem Abstand zueinander angeordneten Kanten 40´´ und 45´ bilden eine mit E bezeichnete Einlaufebene, an welche sich eine mit F bezeichnete Führungsebene und daran eine durch die ebenfalls in parallelem Abstand zueinander angeordneten Kanten 40´ und 46´ gebildete und mit A bezeichnete Auslaufebene anschliesst. Die Einlaufebene E und die Führungsebene F sowie die Auslaufebene A bilden zusammen den Führungskanal 49.

Zur Erreichung einer gleichmässig geführten, etwa berührungslosen Umlenkung des Bonddrahts 26 in dem Führungskanal 49 ist in der einen Trennleiste 40 auf der dem Führungskanal 49 zugewandten Seite mindestens ein Kanal mit Öffnung vorzugsweise. wie in Fig.2 dargestellt, zwei im Abstand zueinander angeordnete Kanäle 41,42 mit Öffnungen 41´,42´ und in der Trennleiste 46 ein Kanal 43 mit Öffnung 43´ sowie in der Trennleiste 45 ein Kanal 44 mit Öffnung 44´ vorgesehen. Die in den Kanälen 41,42 und 43,44 angeordneten Öffnungen oder Bohrungen 41´,42´,43´ und 44´ sind über ein zweites Kanalsystem 68, wie in Fig.3 dargestellt. miteinander verbunden und stehen für die Zuführung eines Druckluftstromes, vorzugsweise eines gesteuerten Druckluftstromes über eine Leitung 69 mit einer entsprechend zugeordneten Druckluftquelle P (Fig.1) in Wirkverbindung. Von den einzelnen, in den entsprechend ausgebildeten Kanälen 41,42,43 und 44 angeordneten Öffnungen oder Bohrungen 41´,42´,43´ und 44´ wird, wie in Fig.2 dargestellt, ein bei den Kanälen 41 und 42 mit P´ und bei den Kanälen 43 und 44 mit P´´ bezeichneter Luftstrom gegen den Bonddraht 26 gerichtet.

In dem etwa quer zur Transportrichtung des Bonddrahtes 26 orientierten Lichtkanal 48 ist zur Lageabtastung des Bonddrahtes 26 ein Abtastorgan, vorzugsweise ein in einem entsprechend ausgebildeten Haltestück 55 angeordneter, optronischer Sensor 56 vorgesehen. Das mit einem buchsenartig ausgebildeten Teilstück 55´´ versehene und in einer in der Auflageplatte 35 und Abdeckplatte 60 vorgesehenen Ausnehmung 34,34´ angeordnete Haltestück 55 ist mit einem Flanschteil 55´ in einer Ausnehmung 10´´ der Trägerplatte 10 mit nicht dargestellten Mitteln (Schraubverbindung) lösbar befestigt. Der Sensor 56 ist in dem Haltestück 55 in axialer Richtung, dass heisst, in Richtung des Lichtkanals 48 verstellbar und das Haltestück 55 in nicht näher dargestellter Weise für eine radiale Verstellung des Sensors 56 mit dem Haltestück 55 entsprechend an der Trägerplatte 10 angeordnet.

Weiterhin erkennt man in Fig.2 ein schematisch und symbolisch dargestelltes Signalauswertgerät 70 sowie eine Steuereinheit oder Steuerelektronik 75, wobei das Signalauswertgerät 70 über eine Leitung 71 mit dem optronischen Sensor 56 und über eine Leitung 72 mit der Steuereinheit 75 und die Steuereinheit 75 über eine Leitung 73 mit dem elektromotorischen Antrieb 20 in Wirkverbindung steht.

In Fig.3 ist die Abzugsstation 30 im Schnitt gemäss der Linie III-III in Fig.2 dargestellt und man erkennt die Trägerplatte 10 mit dem daran angeordneten und befestigten Haltestück 55 für den optronischen Sensor 56 sowie die in diesem Bereich auf dem die Vakuumzone 36 umgebenden Steg 40, auf dem die Vakuumzone 37 umgebenden Steg 46 der Auflageplatte 35 sowie auf dem Steg 45 der Vakuumzone 38 (in Fig.3 nicht dargestellt) angeordnete Abdeckplatte 60. Zur Verdeutlichung ist die Auflageplatte 35 im Bereich der Vakuumzone 36 in aufgebrochenem Zustand dargestellt und man erkennt das an dieser Stelle über die Bohrung 36´ mit der Vakuumzone 36 in Verbindung stehende Kanalsystem 65.

Weiterhin erkennt man das in diesem Bereich über die Bohrung 42´ mit dem Steg 40 und über die Bohrung 43´ mit dem Steg 46 in Verbindung stehende Kanalsystem 68. Die in der Abdeckplatte 60 angeordnete Ausnehmung 48´ sowie in der Auflageplatte 35 angeordnete Ausnehmung 48´´ bilden zusammen den Lichtkanal 48 für den optronischen Sensor 56. Die Abdeckplatte 60 ist vorzugsweise aus transparentem Werkstoff, beispielsweise aus Acrylglas oder dergleichen hergestellt, so dass der durch den Kanal 49 geführte Bonddraht 26 sichtbar ist und gut überwacht und kontrolliert werden kann.

Fig.4 zeigt in Ansicht eine in der Gesamtheit mit 200 bezeichnete zweite Ausführungsform einer Bonddraht-Abzugseinrichtung, welche im wesentlichen eine teilweise aufgebrochen dargestellte und mit einer Druckluftquelle Q in Wirkverbindung stehende Bonddraht-Abzugsstation 130 sowie eine im Abstand dazu an einem Spulenträger 115 gelagerte Bonddraht-Spule 125 umfasst. Der Spulenträger 115 sowie die Spule 125 sind entsprechend dem in Fig.2 in grösserem Massstab dargestellten und vorstehend beschriebenen Spulenträger 15 mit Spule 25 ausgebildet.

Weiterhin erkennt man in Fig.4 ein symbolisch dargestelltes Signalauswertgerät 170 sowie eine Steuereinheit oder Steuerelektronik 175, welche über elektrische Leitungen 171, 172 und 173 einerseits mit einem hier nicht dargestellten, elektromotorischen Antrieb für die um eine Achse 121 in Pfeilrichtung D′ drehbare Spule 125 und andererseits mit einem der Abzugsstation 130 entsprechend zugeordneten optronischen Sensor 156 wirkverbunden sind.

Der Bonddraht-Abzugseinrichtung 200 ist weiterhin eine als Bondkopf ausgebildete Einrichtung 190 zugeordnet, welche zur Ultraschall kontaktierenden Drahtverbindung und zur Bildung von Schaltkreisen oder dergleichen an elektronischen Komponenten 180 (Chips) vorgesehen ist. Die schematisch dargestellte Einrichtung 190 ist analog der in Fig.1 dargestellten Einrichtung 90 ausgebildet und umfasst ein Trägerelement 186, einen Ausleger 184 mit optischem Abtastelement 184′ sowie ein mit einer Kapillare 181, einem Ultraschallhorn 182 (Transducer) und einem Klemmelement 183 versehenes Kontaktierorgan 185. Die Arbeits- und Wirkungsweise der Einrichtung 190 ist mit der vorstehend anhand von Fig.1 beschriebenen Arbeits- und Wirkungsweise der Einrichtung 90 identisch.

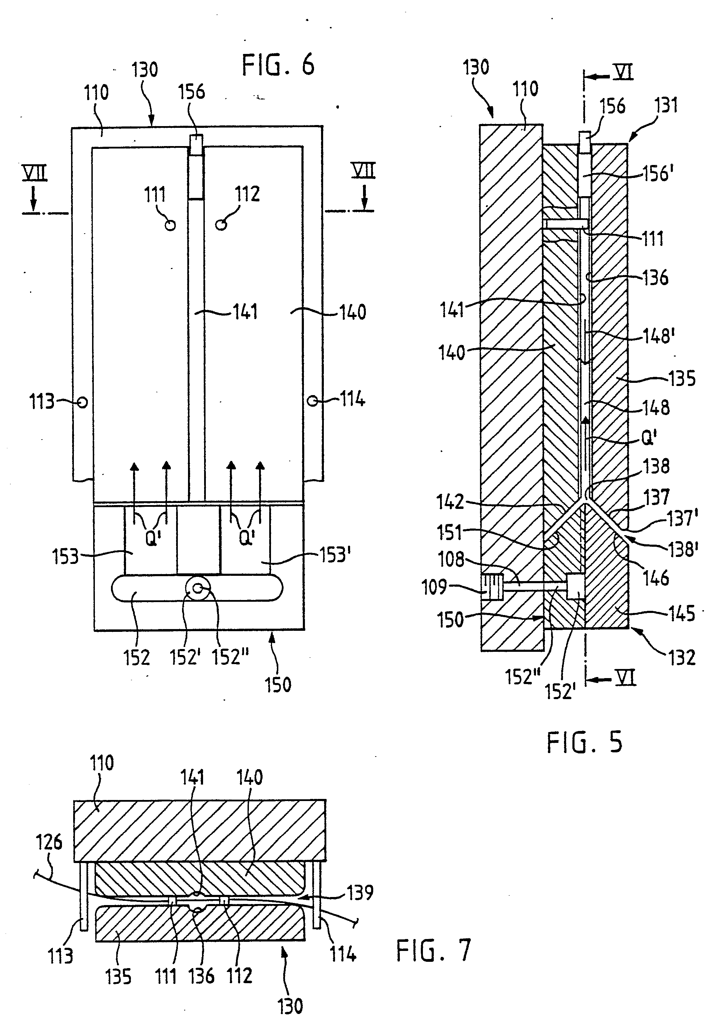

Die als bevorzugtes Ausführungsbeispiel und in den Figuren 5,6 und 7 in grösserem Massstab und im Schnitt dargestellte Bonddraht-Abzugsstation 130 wird nachstehend beschrieben:

Die Abzugsstation 130 umfasst eine Trägerplatte 110, einen daran angeordneten und zur Aufnahme eines optronischen Sensors 156 ausgebildeten Führungskörper 131 sowie einen dem Führungskörper 131 entsprechend zugeordneten Düsenkörper 132, mittels welchem der Bonddraht 126, wie in Fig.4 dargestellt, im wesentlichen von der Spule 125 abgezogen und der als Bondkopf ausgebildeten Einrichtung 190 bereitgestellt wird. Der Führungskörper 131 sowie der Düsenkörper 132 sind mittels einer nicht näher dargestellten Schraubverbindung oder dergleichen an der Trägerplatte 110 befestigt und bilden mit dieser zusammen eine Baueinheit.

Der in der Gesamtheit mit 131 bezeichnete Führungskörper umfasst zwei im Abstand, beispielsweise in parallelem und einen ersten Spalt 139 bildenden Abstand zueinander angeordnete Platten 135 und 140, zwischen welchen der Bonddraht 126 von mindestens einem etwa in Pfeilrichtung Q′ (Fig.6) orientierten Druckluftstrom, vorzugsweise aber von zwei, symmetrisch zu einem Lichtkanal 148 im Abstand zueinander angeordneten Druckluftströmen Q′(Fig.6) beaufschlagt wird. Der mit 139 bezeichnete erste Spalt (Fig.7) zwischen den beiden Platten 135,140 ist so bemessen, dass der Bonddraht 126 von den Druckluftströmen Q′, freischwebend zwischen den beiden Platten 135,140 gehalten und, wie in Fig.4 schematisch dargestellt, im wesentlichen bogenförmig und berührunglos umgelenkt wird.

Zur Erreichung einer aerodynamischen Luftströmung zwischen den beiden Platten 135,140 und Umströmung des Bonddrahtes 126 ist der erste Spalt 139 zwischen den beiden Platten 135,140 in der Grössenordnung von 0,1mm bis 1,0mm gewählt. An dieser Stelle sei darauf hingewiesen, dass die beiden vorzugsweise parallel zueinander angeordneten Platten 135,140 auch in nicht näher dargestellter Weise in Richtung des Sensors 156 leicht geneigt zueinander angeordnet sein können. Hierbei ist der Abstand der Platten 135,140 im Bereich des Düsenköpers 132 etwas grösser als der Abstand im Bereich des Sensors 156.

Durch die regelbaren Druckluftströme Q′ wird der Bonddraht, wie in Fig.4 durch die strichpunktierte Linie dargestellt, zwischen einer oberen und einer unteren Wirkungslinie W,W′ gehalten. Sobald der Bonddraht nach oben oder unten ausserhalb des Wirkungsbereichs W,W′ gelangt, wird mittels einem Signal des Sensors 156 die Druckluftzufuhr entsprechend reguliert.

Die beiden im oberen Bereich durch eine nicht dargestellte Schraubverbindung gehaltenen Platten 135,140 sind je mit einer etwa quer zur Durchlaufrichtung (Fig.4) des Bonddrahtes 126, dass heisst, in vertikaler Richtung orientierten Ausnehmung 136,141 versehen. Die nutartig ausgebildeten Ausnehmungen 136,141 bilden in zusammengebautem Zustand einen Lichtkanal 148 für den Sensor 156.

Im oberen Bereich des Lichtkanals 148 ist der mit einer entsprechend ausgebildeten Fassung 156′ versehene und gehaltene Sensor 156 angeordnet, welcher beispielsweise durch die miteinander verschraubten Platten 135,140 gehalten ist. Der Lichtkanal 148 ist in seiner Formgebung der Sensorfassung 156′ beziehungsweise dem Sensor 156 angepasst und, wie in Fig.7 dargestellt, im Profilquerschnitt kreisförmig ausgebildet. Der Lichtkanal 148 hat vorzugsweise eine durch eine spezielle Behandlung möglichst total reflektierende Oberfläche für den durch Pfeilrichtung 148' bezeichneten Lichtstrahl. Eine Reflektion des vom Sensor 156 abgegebenen und wieder empfangenen Lichtstrahls 148' soll ausschliesslich von dem vorzugsweise durch das Zentrum (Fig.7) des Lichtstrahls 148' geführten Bonddraht 126 erfolgen. Um diese Forderung zu optimieren, sind die verbleibenden und entsprechend zugewandten Spalt-Innenflächen (nicht bezeichnet) der Platten 135,140 sowie der zugeordnete und mit entsprechend geneigten Flächen 146,151 versehene Düsenkörper 132 zur Vermeidung von unerwünschten Reflektionen vorzugsweise mit schwarz matierter Oberfläche versehen.

Im Abstand zu der nicht näher bezeichneten Unterkante des Sensors 156 beziehungsweise zu der Sensorfassung 156' ist, wie in Fig.6 dargestellt, zu beiden Seiten der Ausnehmung 141 ein Zapfen 111,112 oder dergleichen in der Platte 140 angeordnet. Mittels der beiden Zapfen 111 und 112 wird, wie in Fig.4 durch die obere gestrichelte Linie 126' dargestellt, die obere Endlage des Bonddrahtes 126 in bezug zu dem Sensor 156 bestimmt. Die beiden Zapfen 111,112 sind in entsprechend in der Platte 140 vorgesehene, nicht näher bezeichnete Bohrungen (Fig.5) eingesteckt und mit nicht dargestellten Mitteln gehalten.

Die in Fig.4 durch die gestrichelte Linie 126" dargestellte untere Endlage des Bonddrahtes 126 wird durch zwei weitere in der Trägerplatte 110 angeordnete Zapfen 113,114 bestimmt. Die im Abstand zueinander angeordneten und in nicht näher dargestellter Weise in der Trägerplatte 110 befestigten Zapfen 113,114 verhindern gleichzeitig, dass bei ausgeschalteter Druckluftquelle Q, der Bonddraht 126 aus der Abzugsstation 130 beziehungsweise aus dem Führungskörper 131 herausfällt.

Im unteren Bereich sind die beiden Platten 135,140 des Führungskörpers 131 je mit einer abgeschrägten Fläche 137,142 versehen. Die beiden Flächen 137,142 sind in zusammengebautem Zustand derart zueinander angeordnet, dass dieselben eine etwa keilförmige, nicht näher bezeichnete Ausnehmung bilden. Die Flächen 137,142 sind etwa in der Grössenordnung von 45° abgeschrägt, so dass diese eine Ausnehmung von etwa 90° bilden.

Der dem Führungskörper 131 entsprechend zugeordnete Düsenkörper 132 umfasst eine erste Platte 145 und eine zweite Platte 150. Die beiden Platten 145,150 sind durch eine nicht dargestellte Schraubverbindung miteinander verbunden als eine den Düsenkörper 132 bildende Baueinheit ausgebildet. Auf der den beiden Platten 135,140 des Führungskörpers 131 zugewandten Seite sind die beiden Platten 145,150 des Düsenkörpers 132 mit einer abgeschrägten Fläche 146,151 versehen. In montiertem Zustand ist der Düsenkörper 132, wie in Fig.5 dargestellt, mit dem aus den Flächen 146,151 gebildeten und nicht näher bezeichneten Keilstück in der durch die beiden Flächen 137,142 gebildeten, keilförmigen Ausnehmung der Platten 135, 140 angeordnet.

In montiertem Zustand (Fig.5), in welchem der Führungskörper 131 sowie der Düsenkörper 132 an der Trägerplatte 110 befestigt sind, ist zwischen den korrespondierend zueinander angeordneten Flächen 137,146 und 142,151 ein Spalt, mindestens aber zwischen den beiden FLächen 137,146 ein zweiter, mit 138 bezeichneter Spalt vorgesehen. Der zweite Spalt 138 ist zum Einfädeln des Bonddrahtes 126 vorgesehen und ausgebildet. Die vordere Kante der Fläche 137 ist vorzugsweise mit einer ausreichenden Abrundung 137' versehen.

An dieser Stelle sei darauf hingewiesen, dass die an der Trägerplatte 110 angeordnete und durch eine Schraubverbindung befestigte Platte 140 des Führungskörpers 131 im unteren Bereich als ein nicht dargestelltes Düsenteil ausgebildet werden kann, welches im wesentlichen die beiden Kanäle 153,153' sowie die Ausnehmung 152 mit Bohrungen 152',152" umfasst.

Die Platte 150 des Düsenkörpers 132 ist, wie in Fig.6 darge stellt, auf der der Platte 145 zugewandten Seite mit einer als Längsnut ausgebildeten Ausnehmung 152 versehen, an welche sich mindestens ein orthogonal dazu angeordneter und über die gesamte Breite der Ausnehmung verlaufender Kanal anschliesst (nicht dargestellt). Bei dem dargestellten und bevorzugten Ausführungsbeispiel sind zwei durch einen Steg 154 voneinander getrennte Kanäle 153,153' für die in Pfeilrichtung Q' orientierten Druckluftströme vorgesehen. Die Ausnehmung 152 ist über eine erste Bohrung 152' sowie über eine zweite Bohrung 152" mit einer in der Trägerplatte 110 vorgesehenen Bohrung 108 und Gewindebohrung 109 verbunden. Die Gewindebohrung 109 ist für den Anschluss der mit der Druckluftquelle Q (Fig.4) in Verbindung stehenden Leitung 169 vorgesehen. Die aneinanderliegenden Seiten der beiden Platten 145,150 haben eine absolut ebene, vorzugsweise geschliffene Fläche, so dass der von der Druckluftquelle eingeleitete Druckluftstrom Q' über die beiden Kanäle 153,153' in den zwischen den beiden Platten 135,140 vorgesehenen ersten Spalt 139 gelangt und dabei den Bonddraht 126 in seiner Lage haltend entsprechend beaufschlagt wird.

In Fig.7 ist die Abzugsstation 130 im Schnitt gemäss der Linie VII-VII in Fig.6 dargestellt, und man erkennt die Trägerplatte 110, die daran befestigten Platten 140,135 sowie den dazwischen im ersten Spalt 139 angeordneten Bonddraht 126. Das Mass oder die Breite des zwischen den beiden Platten 135,140 vorgesehenen und in Fig.5 und 7 grösser dargestellten Spalts 139 liegt zur Erreichung einer optimalen Luftströmung etwa in der Grössenordnung von 0,1mm bis 1,0mm.

Die Arbeits- und Wirkungsweise der Bonddraht-Abzugsstation 30 oder 130 in Verbindung mit dem elektromotorisch angetriebenen Spulenträger 15 oder 115 wird nachstehend beschrieben:

In der Arbeitsstellung wird bei der Abzugsstation 30 die Abdeckplatte 60, welche auf den jeweils mit absolut ebener Auflagefläche versehenen Trennleisten 40, 45 und 46 der Auflageplatte 35 aufliegt, mittels eines in den Vakuumzonen 36, 37 und 38, von der Vakuumpumpe V erzeugten Unterdrucks fest an der Auflageplatte 35 gehalten und bildet mit dieser im wesentlichen eine Baueinheit. Zur Erzeugung des Unterdrucks sind die Vakuumzonen 36,37 und 38 über die Bohrungen 36´, 36˝,37´ und 38´ und dem Kanalsystem 65 mit der Vakuumpumpe V verbunden.

Der von der Bonddrahtspule 25 abgezogene und in den Führungskanal 49 zwischen der Auflageplatte 35 und Abdeckplatte 60 beispielsweise manuell eingelegte Bonddraht 26 wird während des Betriebs etwa im mittleren Bereich, wie in Fig.2 dargestellt, von den beiden mit Pfeilrichtung P´ bezeichneten Luftströmen zur Bildung einer Bonddrahtreserve in Richtung zum optronischen Sensor 56 etwa gegen die beiden Teilstücke 47´,47˝ des mittleren Trennelements 47 sowie gegen die schrägen Anlagekanten 45´ und 46´ der Trennleisten 45 und 46 bewegt und gleichzeitig sowie entgegengesetzt zu Pfeilrichtung P´ von den mit Pfeilrichtung P˝ bezeichneten Luftströmen in Richtung zu den schrägen Kanten 40´ und 40˝ der Trennleiste 40 bewegt. Die beiden Luftströme P˝ sind so eingestellt, dass der Bonddraht 26 in der Einlaufebene E sowie in der Auslaufebene A etwa eine im mittleren Bereich des Führungskanals 49 orientierte Position einnimmt. Die einzelnen Luftströme P´ und P˝ bewirken hierbei etwa die Funktion einer Umlenkrolle oder dergleichen und gewährleisten einen steuerbaren, konstanten Zug am Bonddraht 26 sowie einen gleichmässigen Abzug (kein Durchhängen) von der Bonddrahtspule 25. In der in Fig.2 dargestellten Lage ist der Bonddraht 26 im Wirkungsbereich oder Sichtbereich des optronischen Sensors 56, in welcher der den Vorschub des Bonddrahtes bewirkende elektromotorische Antrieb 20 ist ausser Funktion.

Beim Bondvorgang wird der von der Klemmvorrichtung gehaltene Bonddraht 26, wie in Fig.1 dargestellt mit Pfeilrichtung Z, durch die Bewegung des Kontaktierorgans 85 oder aber durch die Bewegung der Einrichtung 90 (Bondkopf) aus der Abzugsstation 30 gezogen und gelangt dadurch etwa in die in Fig.2 gestrichelt dargestellte Position (abnehmende Bonddrahtreserve) und somit aus dem Wirkungs- oder Sichtbereich des optronischen Sensors 56. Von dem Sensor 56 wird dann über die Leitung 71 ein entsprechendes Signal dem Signalauswertgerät 70 zugeführt und darin verarbeitet. Von dem Auswertgerät 70 wird anschliessend über die Leitung 72 der Steuereinheit 75 ein Schaltimpuls zugeführt und von dort über die Leitungen 73,74 der elektromotorische Antrieb 20 angesteuert und entsprechend aktiviert. Der Antrieb 20 bleibt dabei solange aktiviert oder angesteuert bis der von der Spule 25 freigegebene Bonddraht 26 durch die entsprechenden Luftströme wieder in den Funktionsbereich des Sensors 56 bewegt ist, von welchem dann über einen weiteres, entsprechendes Signal ein Stillstand des elektromotorischen Antriebs 20 bewirkt und erreicht wird.

Die im wesentlichen als eine Baueinheit ausgebildete und vorzugsweise an einem nicht dargestellten stationären Maschinenteil in einer Schräglage angeordnete Bonddraht-Abzugseinrichtung 100 kann als kasettenartig ausgebildete, auswechselbare Funktionseinheit ausgebildet sein, mittels welcher der hochempfindliche Bonddraht 26 durch berührungslose Detektion von der Bonddraht-Spule abgezogen und im wesentlichen der Einrichtung 90 (Bondkopf) zuführbar ist.

Die beiden Abzugseinrichtungen 100 und 200 unterscheiden sich einerseits in der baulichen Anordnung der Abzugsstation an der entsprechenden Trägerplatte 10 und 110 und andererseits durch das Einlegen oder Einführen des Bonddrahts in die Abzugsstation.

Bei der einen Abzugseinrichtung 100 ist die Abzugsstation 30 an der Trägerplatte 10 in einer geneigten Position montiert und bei der zweiten, bevorzugten Abzugseinrichtung 200 ist die Abzugsstation 130 in bezug zu der Trägerplatte 110 in paralleler beziehungsweise in vertikaler Position montiert.

Abweichend von der Abzugsstation 30, bei welcher der Bonddraht 26 nach Abnahme der Abdeckplatte 60 in den Führungskanal 49 eingelegt wird, wird bei der Abzugsstation 130 in dem zwischen dem Führungskörper 131 und dem Düsenkörper 132 vorgesehenen zweiten Spalt 138 durch die Druckluftströme Q´ eine etwa in Pfeilrichtung 138´ orientierte Ansaug-Wirkung erreicht, mittels welcher der Bonddraht 126 durch den zweiten Spalt 138 in den zwischen den beiden Platten 135 und 140 vorgesehenen ersten Spalt 139 (Fig.7) weitgehend berührungslos eingefädelt wird. In dem ersten Spalt 139 wird der im Profilquerschnitt kreisförmige Bonddraht 126 von dem Luftstrom Q´ derart umströmt, dass der Bonddraht 126 selbstzentrierend im Zentrum des Luftstroms Q´ und somit in der Mitte des zwischen den Platten 135,140 vorgese-

nen ersten Spalts 139 angeordnet und fliegend (schwebend) gehalten ist. Die etwa vertikale Position (Lage) des Bonddrahtes 126 in dem ersten Spalt 139 ist abhängig von dem Luftstrom $Q'$, wobei die obere Position von den beiden Zapfen 111,112 und die untere Position durch die Zapfen 113,114 begrenzt ist.

Bei der Bonddraht-Abzugseinrichtung 200 erfolgt das Ermitteln und die Verarbeitung der entsprechenden Signale im wesentlichen wie bei der vorstehend im Zusammenhang mit der Abzugseinrichtung 100 beschrieben.

## Ansprüche

1. Verfahren zum Bereitstellen eines Bonddrahtes zur Bildung von Schaltkreisen an elektronischen Komponenten, bei welchem der Bonddraht in einer Abzugsstation durch mindestens einen quer zur Transportrichtung orientierten Luftstrom zur Bildung einer Drahtreserve beaufschlagt und zur Ansteuerung eines mit der Spule in Wirkverbindung stehenden elektromotorischen Antriebs von einem Sensor optronisch detektiert oder abgetastet wird, dadurch gekennzeichnet, dass der Bonddraht (26 oder 126) von einem einzigen, quer zur Transportrichtung angeordneten Sensor (56 oder 156) detektiert und von mindestens einem im wesentlichen entgegengesetzt in Richtung des Sensors (56 oder 156) orientierten ersten Luftstrom ($P'$ oder $Q'$) im optischen Wirkungsbereich des Sensors (26 oder 156) gehalten wird, und dass sobald der Bonddraht (26 oder 126) den optischen Wirkungsbereich des Sensors (56 oder 156) verlässt von diesem ein den elektromotorischen Antrieb entsprechend betätigendes Signal zur Bildung einer neuen Drahtreserve erzeugt wird.

2. Verfahren nach Anspruch 1, dadurch gekennzeichnet, dass der Bonddraht (26 oder 126) in Abhängigkeit von dem Signal des Sensors (56 oder 156) von zwei, symmetrisch im Abstand zu beiden Seiten des Lichtkanals (48 oder 148) angeordneten und im wesentlichen in Richtung des Sensors (56 oder 156) orientierten ersten Luftströmen ($P'$ oder $Q'$) einer Druckluftquelle (P oder Q) im optischen Wirkungsbereich des Sensors (56 oder 156) gehalten wird.

3. Verfahren nach Anspruch 1 und 2, dadurch gekennzeichnet, dass der von den beiden in Richtung des einzigen Sensors (56) orientierten ersten Luftströmen ($P'$) im optischen Wirkungsbereich gehaltene Bonddraht (26) von zwei weiteren, symmetrisch und im Abstand zum Lichtkanal (48) angeordneten und etwa entgegengesetzt zu den ersten Luftströmen ($P'$) orientierten zweiten Luftströmen ($P''$) beaufschlagt wird.

4. Bonddraht-Abzugseinrichtung zur Durchführung des Verfahrens nach einem der Ansprüche 1 bis 3, bestehend aus einem mit einem elektromotorischen Antrieb wirkverbundenen Spulenträger (15 oder 115) für eine Spule (25 oder 125) und einer entsprechend zugeordneten Abzugsstation (30 oder 130), mit zwei im Abstand zueinander angeordneten Platten (35,60 oder 135,140), zwischen welchen der von mindestens einem Luftstrom einer Druckluftquelle beaufschlagte Bonddraht zur Bildung einer Drahtreserve angeordnet ist, dadurch gekennzeichnet, dass
- in den beiden Platten (35,60 oder 135,140) je eine quer zur Transportrichtung des Bonddrahtes (26 oder 126) orientierte und in zusammengebautem Zustand der Platten (35,60 oder 135,140) einen Lichtkanal (48 oder 148) bildende Ausnehmung ($48'$,$48''$ oder 136,141) für einen optronischen Sensor (56 oder 156) angeordnet ist, und
- die Abzugsstation (30 oder 130) für die jeweils erforderlichen Luftströme ($P'$,$P''$ oder $Q'$) entweder über Kanalsystem (41,42,43,44) oder über einen entsprechend zugeordneten Düsenkörper (132) mit der Druckluftquelle (P oder Q) wirkverbunden sind.

5. Bonddraht-Abzugseinrichtung nach Anspruch 4, dadurch gekennzeichnet, dass
- die erste Platte (35) der Abzugsstation (30) im Abstand zueinander angeordnete Trennleisten (40,45,46) aufweist, welche einen mit einer Einlaufebene (E), einer Führungsebene (F) und einer Auslaufebene (A) versehenen, quer zum Lichtkanal (48) angeordneten Führungskanal (49) bilden,
- die auf der einen Seite des Führungskanals (49) angeordnete Trennleiste (40) mit entsprechend in den Führungskanal (49) gerichteten Kanälen (41,42) für Luftströme ($P'$) und die gegenüber auf der anderen Seite des Führungskanals (49) angeordneten Trennleisten (45,46) ebenfalls mit in den Führungskanal (49) gerichteten Kanälen (43,44) für Luftströme ($P''$) versehen sind, und
- die zweite, als Abdeckplatte ausgebildete Platte (60) mittels zusätzlich in den Trennleisten (40,45,46) angeordneter sowie mit einer Vakuumpumpe (V) wirkverbundener Vakuumzonen (36,37,38) an der ersten Platte (35) gehalten ist.

6. Bonddraht-Abzugseinrichtung nach Anspruch 4 und 5, dadurch gekennzeichnet, dass der optronische Sensor (56) der Abzugsstation (30) in einem an der Trägerplatte (10) befestigten Haltestück (55) derart angeordnet ist, dass dieser mindestens in bezug zu der gegenüberliegenden Trennleiste (40) in Längsrichtung des Lichtkanals (48) und vorzugsweise mit dem Haltestück (55) in bezug zum Lichtkanal (48) im wesentlichen radial verstellbar ist.

7. Bonddraht-Abzugseinrichtung nach Anspruch 4, dadurch gekennzeichnet, dass die mit dem Lichtkanal (148) versehene Abzugsstation (130) einen aus den beiden im Abstand und mit einem ersten Spalt (139) zueinander angeordneten Platten (135,140) gebildeten Führungskörper (131) sowie den Düsenkörper (132) mit entsprechend in den ersten Spalt (139) gerichteten Luftkanälen (153,153′) umfasst, wobei der Führungskörper (131) mit dem Düsenkörper (132) als eine Baueinheit in vertikaler Richtung an einer Trägerplatte (110) so angeordnet ist, dass der Lichtkanal (148) in der Ebene des Bonddrahtes (126) und orthogonal zum durchlaufenden Bonddraht (126) angeordnet ist.

8. Bonddraht-Abzugseinrichtung nach Anspruch 4 und 7, dadurch gekennzeichnet, dass zwischen dem Führungskörper 131) und dem Düsenkörper (132) ein über die gesamte Breite der beiden Körper (131,132) verlaufender und in Durchlaufrichtung des Bonddrahtes (126) orientierter zweiter Spalt (138) vorgesehen ist, welcher zur Erzeugung einer den Bonddraht einfädelnden Saugwirkung mit dem vom Düsenkörper (132) mit mindestens einem Druckluftstrom (Q′) beaufschlagten ersten Spalt (139) verbunden ist, und dass der Abstand der Platten (135,140) für den ersten Spalt (139) in der Grössenordnung von 0,1mm bis 1,0mm liegt und der zweite Spalt (138) etwa dem ersten Spalt (139) entspricht.

9. Bonddraht-Abzugseinrichtung nach Anspruch 4, dadurch gekennzeichnet, dass die quer zur Durchlaufrichtung des Bonddrahts (26,126) in den Platten (35,60 oder 135,140) angeordneten Ausnehmungen (48′,48″ oder 136,141) in zusammengebauten Zustand der Platten jeweils einen im Profilquerschnitt kreisförmigen und mit möglichst total reflektierender Oberfläche versehenen Lichtkanal (48 oder 148) bilden.

10. Bonddraht-Abzugseinrichtung nach Anspruch 4, dadurch gekennzeichnet, dass der mit dem Spulenträger (15 oder 115) wirkverbundene und mit einem Reduktionsgetriebe versehene elektromotorische Antrieb (20) in einem Trägerelement (17) angeordnet und das Trägerelement (17) in dem Spulenträger (15,115) integriert sowie mit diesem als eine Baueinheit ausgebildet ist.

11. Bonddraht-Abzugseinrichtung nach Anspruch 4, dadurch gekennzeichnet, dass die Abzugsstation (30 oder 130) als eine kassettenartig auswechselbare Baueinheit ausgebildet ist.

FIG. 1

FIG. 3

FIG. 2

FIG. 4

FIG. 6

FIG. 5

FIG. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4 ) |
|---|---|---|---|
| A, D | EP-A-130104 (FAIRCHILD)<br>* Seite 22, Absatz 1 - Seite 23, Absatz 1; Figur 1 *<br>---- | 1, 4 | H01L21/00 |
| A, D | EP-A-226126 (SIEMENS)<br>* das ganze Dokument *<br>---- | 1, 4 | |
| A | US-A-4179597 (BARTHOLET)<br>* Zusammenfassung; Figur 8 *<br>--- | 1, 4 | |
| A | EP-A-157081 (IBM)<br>* Seite 5 - 8, Zeile 7; Figuren 1, 3, 7 *<br>----- | 1, 4 | |

| RECHERCHIERTE SACHGEBIETE (Int. Cl.4 ) |
|---|
| H01L<br>H05K<br>H01R<br>B65H |

Der vorliegende Recherchenbericht wurde für alle Patentansprüche erstellt

| Recherchenort | Abschlußdatum der Recherche | Prüfer |
|---|---|---|
| DEN HAAG | 13 JULI 1989 | TIELEMANS H.L.A. |